# EUROPEAN PATENT SPECIFICATION

(11) **EP 4 336 304 B1**
(45) Date of publication and mention of the grant of the patent: **01.04.2026**
(21) Application number: 22216887.4
(22) Date of filing: 28.12.2022
(51) Int. Cl.: G06F 1/16, H04M 1/02, H04M 1/18, G03B 17/08, H04B 1/3888

(54) **WATERPROOF STRUCTURE, ELECTRONIC DEVICE AND MANUFACTURING METHOD OF WATERPROOF STRUCTURE**
WASSERDICHTE STRUKTUR, ELEKTRONISCHE VORRICHTUNG UND HERSTELLUNGSVERFAHREN FÜR WASSERDICHTE STRUKTUR
STRUCTURE ÉTANCHE À L'EAU, DISPOSITIF ÉLECTRONIQUE ET PROCÉDÉ DE FABRICATION DE STRUCTURE ÉTANCHE À L'EAU

(30) Priority: 08.09.2022 CN 202211098281
(43) Date of publication of application: 13.03.2024
(73) Proprietor: Beijing Xiaomi Mobile Software Co., Ltd., Beijing 100085 (CN)
(72) Inventor: CHENG, Quanchang, Beijing, 100085 (CN)
(74) Representative: dompatent

(56) References cited:
- CN-U- 207 603 338
- CN-U- 212 786 303
- US-A1- 2014 160 680
- US-A1- 2021 200 272
- US-A1- 2021 282 286

## Description

### TECHNICAL FIELD

The disclosure relates to the field of waterproofing of electronic devices, in particular to a waterproof structure, an electronic device using the waterproof structure, and a manufacturing method of the waterproof structure.

### BACKGROUND

With the continuous enrichment of people's life scenes, the functional requirements of electronic devices are more and more diversified and complicated, and especially the requirement of waterproof performance of the electronic devices is higher and higher. In related art, a waterproof structure is additionally arranged in an electronic device to implement the waterproof performance, however, the design of the waterproof structure is challenged in cost, structural space, waterproof performance and other aspects.

CN212786303U discloses a detector with a waterproof structure and convenient to fix, which comprises a fixing plate, a detection head is fixedly mounted in the center of the lower end of the fixing plate, a protective cover for protecting the detection head is sleeved on the detection head, and a mounting block is fixedly connected to one end, close to the fixing plate, of the protective cover. A sealing waterproof mechanism used for sealing a gap between the fixing plate and the protective cover and preventing water from entering the protective cover is arranged in the mounting block, and a fixing mechanism facilitating dismounting and mounting of the fixing plate is arranged at the end, away from the protective cover, of the fixing plate. The fixing plate and the protective cover are rapidly installed in a butt joint mode through the positioning rod and the positioning groove, water in the positioning groove is absorbed through the water absorption sponge and the water absorption expansion sealing block, the water absorption expansion sealing block expands after absorbing water, and the positioning groove is sealed. And the fixing plate is detachably connected to the base.

CN207603338U discloses a waterproof motor, including casing, inside be provided with drive mechanism the front end housing, be provided with the rear end cap of electronic mechanism, the control switch at casing top, the rear end cap front end is provided with the vent, it is provided with the dog to be located the vent, the capillary is worn to establish in the space of dog, be provided with the sponge that absorbs water in the cavity, it is provided with and support leans on it in the spring of vent department to absorb water the sponge rear end, the spring holder that the spring passes through to set up on the baffle in the rear end cap cavity is fixed, it is provided with the louvre to lie in on the baffle between two spring holders, through with setting up the waterproof construction in the rear end cap, and match the installation form of screw thread, not only install, dismantle simply, and ventilate, water prevention, can prolong the life of starter.

### SUMMARY

In order to solve the problem existing in the related art, the disclosure provides a waterproof structure, an electronic device using the waterproof structure provided by the disclosure, and a manufacturing method of the waterproof structure provided by the disclosure.

According to a first aspect of the invention, a waterproof structure is provided and includes a base body and a liquid storing part arranged on the base body in a protruding mode, and the base body has a water absorbing part located on an edge and communicating with the liquid storing part. The waterproof structure is configured to allow water vapor to enter into the liquid storing part through the water absorbing part, and be centrally discharged to the outside when a water volume in the liquid storing part reaches a preset value.

According to the first aspect of the present invention, the base body includes a first membrane layer and a second membrane layer disposed in a stacked mode, in which the liquid storing part includes a bulge formed by the second membrane layer protruding in a direction away from the first membrane layer, and a liquid storing cavity communicating with the water absorbing part is formed between the bulge and the first membrane layer.

Optionally, the liquid storing part further includes a water locking body arranged on the first membrane layer and located in the liquid storing cavity, and the water locking body is of hollowed-out structure, protrudes in the same direction as the bulge, and is spaced from the bulge.

Optionally, there are more than one liquid storing parts arranged in a matrix mode, which include first liquid storing parts located in an edge region and second liquid storing parts located in a middle region, and the second liquid storing parts located in the middle region, the first liquid storing parts located on two sides of the water absorbing part, the first liquid storing parts and the adjacent second liquid storing parts communicate with one another respectively.

Optionally, the bulge is constructed as air sac, the water locking body is constructed as net structure buckled on the first membrane layer and matched with the air sac in shape, every two adjacent net structures communicate with each other through a capillary groove, and every two adjacent air sacs communicate with each other through a channel.

Optionally, the base body has an edge covering region located on a periphery of the edge region, and the edge covering region and the edge provided with the water absorbing part jointly constitute an outer contour of the base body.

Optionally, the water absorbing part includes one or more water absorbing channels, one end of the water absorbing channel extends to the edge provided with the water absorbing part, and the other end of the water absorbing channel extends to the liquid storing part closest to the edge.

Optionally, the waterproof structure further includes a fixed layer, and the fixed layer is arranged on a surface facing away from the liquid storing part of the base body.

According to a second aspect of the invention, an electronic device is provided and includes one or more structural members and the above waterproof structure, and the waterproof structure is arranged on at least one of the structural members.

Optionally, the electronic device includes a first structural member and a second structural member, an interval and an opening communicating with the outside are formed between the first structural member and the second structural member, the waterproof structure is arranged in the interval, and the water absorbing part is arranged towards the opening.

Optionally, a first surface of the first structural member is in butt joint with a second surface of the second structural member to form the interval, the opening is formed at one end of the first surface and one end of the second surface, the second structural member is located on an outer side of the first structural member, and the liquid storing part protrudes towards the second structural member.

According to a third aspect of the invention, a manufacturing method of a waterproof structure is provided and used for processing the above waterproof structure, and the manufacturing method includes the steps:
processing the liquid storing part on the base body; and
processing the water absorbing part on the base body, and making the water absorbing part extend from the liquid storing part to a first edge of the base body.

Optionally, the base body includes a first membrane layer and a second membrane layer disposed in a stacked mode, and the step of processing the liquid storing part on the base body includes:
providing the first membrane layer;
pressing more than one bulges on the second membrane layer, every two adjacent bulges communicating with each other through a channel; and
disposing the first membrane layer and the second membrane layer in a stacked mode, and performing press fit sealing along other edges other than the first edge.

Optionally, in the step of providing the first membrane layer, more than one water locking bodies are fixed on the first membrane layer in an injection molding mode, and every two adjacent water locking bodies communicate with each other through a capillary groove; and
in the step of disposing the first membrane layer and the second membrane layer in the stacked mode, the bulges correspond to the water locking bodies in position, and the water locking bodies are sealed in liquid storing cavities between the bulges and the first membrane layer.

The technical solution provided by the example of the disclosure may include the following beneficial effects: the waterproof structure provided by the disclosure may be disposed at any appropriate position during practical application, when water vapor exists in an opening of the water absorbing part, under the capillary action of the water absorbing part, the water vapor is absorbed into the liquid storing part, when water is stored to a certain amount, external force may be applied to discharge water in the liquid storing part to complete one internal recycle and enter a next waterproof recycle, a waterproof function may be implemented, repetitive cycle utilization may further be implemented, excessive structural space may not be occupied, and processing is convenient and the cost is low.

### BRIEF DESCRIPTION OF THE DRAWINGS

The accompanying drawing here are incorporated into and form a part of the specification, show examples conforming to the disclosure, and are used to explain principles of the disclosure with the specification.
Fig. 1 is a schematic diagram of installation of a waterproof structure shown according to an example.
Fig. 2 is a sectional view of a waterproof structure shown according to an example.
Fig. 3 is an explosive view of a waterproof structure shown according to an example.
Fig. 4 is a front view of a waterproof structure shown according to an example.
Fig. 5 and Fig. 6 are flow diagrams of a manufacturing method of a waterproof structure shown according to an example.

### DETAILED DESCRIPTION

Examples are described in detail here, as exemplified in the accompanying drawings. When the following description refers to the accompanying drawings, unless otherwise indicated, the same number in different accompanying drawings indicates the same or similar elements. The examples described in the examples below do not represent all examples consistent with the disclosure. Rather, the examples are merely examples of apparatuses and methods that are consistent with some aspects of the disclosure as detailed in the appended claims.

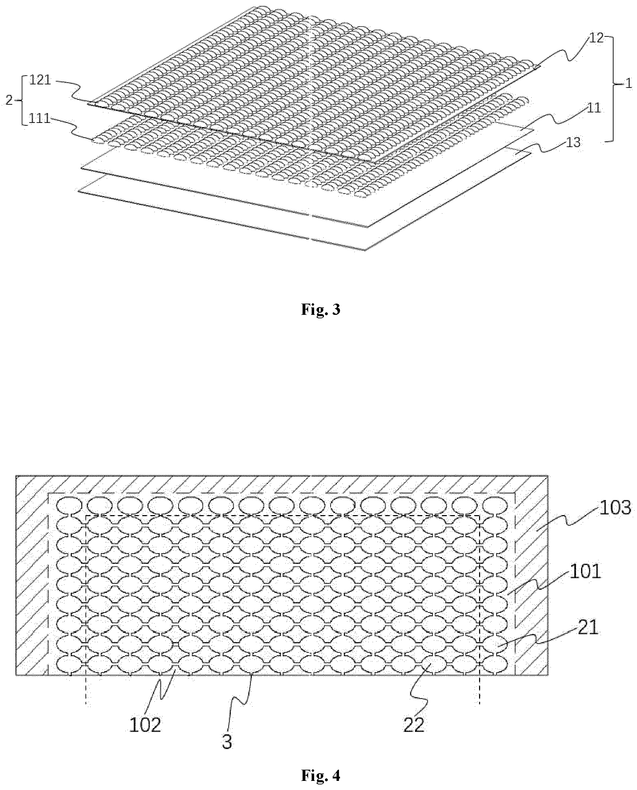

In the disclosure, without opposite explanation, used location words such as "top" and "bottom" refer to the normal use of products, specifically referring to directions shown in Fig. 3, and "inner" and "outer" refer to inner and outer of an outline of a corresponding component. In addition, terms such as "first" and "second" used in the disclosure are intended to distinguish one element from another element, and do not represent any sequence or importance. When the description below refers to the accompanying drawings, unless otherwise indicated, the same number in different accompanying drawings indicates the same or similar elements.

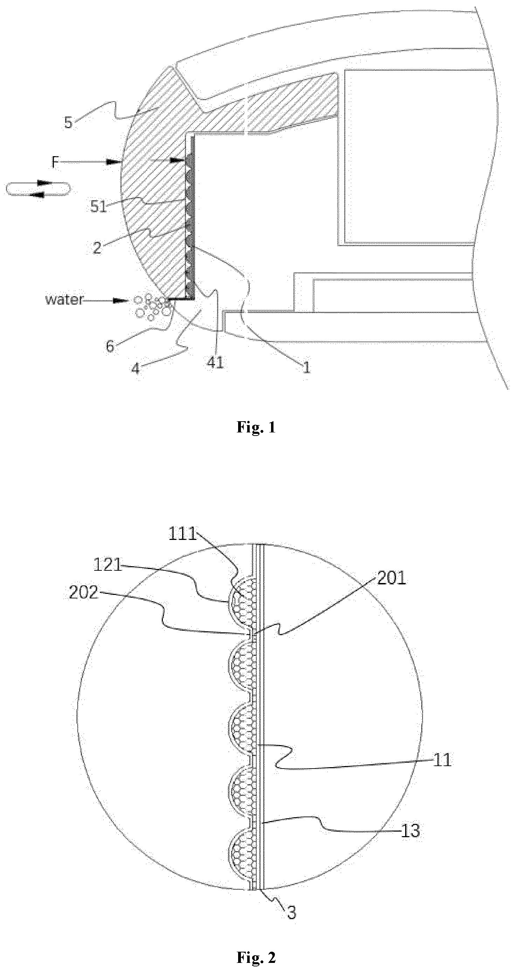

There are many ways to implement the waterproof function, for example, the structural surface is designed as a hydrophobic material, or the structure itself could absorb water, so as to prevent water from entering an interior of an electronic device, and the design of the waterproof structure should comprehensively consider the waterproof performance, structural space, processing cost and other factors. Based on this, as shown in Fig. 1 to Fig. 4, the disclosure provides a waterproof structure. The waterproof structure includes a base body 1 and a liquid storing part 2 arranged on the base body 1 in a protruding mode. The base body 1 has a water absorbing part 3 located at an edge and communicating with the liquid storing part 2. The waterproof structure provided by the disclosure is configured to allow water vapor to enter into the liquid storing part 2 through the water absorbing part 3, and be centrally discharged to the outside when a water volume in the liquid storing part 2 reaches a preset value.

Here, it should be noted that the base body 1 may be in any appropriate shape, such as a square and a circle, and the following will take the waterproof structure as a square sheet as an example to explain in detail. There are many ways to form the liquid storing part 2 on the base body 1, for example, injection molding or compression molding may be directly adopted. The waterproof structure provided by the disclosure may be applied to electronic devices such as a mobile phone, a camera and a wearable device. Taking the waterproof structure applied to the mobile phone as an example, there may be various using scenarios of the waterproof structure in the disclosure, for example, in an environment where water vapor is heavy, the water vapor enters the liquid storing part 2 through the water absorbing part 3 to play a waterproofing role. Certainly, the liquid storing capacity of the liquid storing part 2 may be designed to make the waterproof structure applied to an environment full of water, for example, during swimming, when the mobile phone accidentally falls into water, the waterproofing effect is achieved.

The waterproof function refers to prevent water or water vapor or other liquids from entering an interior of an electronic device. The water vapor will accumulate continuously after entering the liquid storing part 2, and a certain amount of water will be stored in the liquid storing part 2. Therefore, the "water vapor" here could be equivalent to water or other liquids.

The waterproof structure provided by the disclosure may be disposed at any appropriate position during practical application, when water vapor exists in an opening of the water absorbing part 3, under the capillary action of the water absorbing part 3, the water vapor is absorbed into the liquid storing part 2, when water is stored to a certain amount, as shown in Fig. 1, external force F may be applied to discharge water in the liquid storing part 2 to complete one internal recycle and enter a next waterproof recycle, a waterproof function may be implemented, repetitive cycle utilization may further be implemented, excessive structural space may not be occupied, and processing is convenient and the cost is low.

In an example of the disclosure, and according to the first aspect of the invention, as shown in Fig. 2 and Fig. 3, the base body 1 includes a first membrane layer 11 and a second membrane layer 12 disposed in a stacked mode, the liquid storing part 2 includes a bulge 121 formed by the second membrane layer 12 protruding in a direction away from the first membrane layer 11, and a liquid storing cavity communicating with the water absorbing part 3 is formed between the bulge 121 and the first membrane layer 11. Here, the first membrane layer 11 and the second membrane layer 12 may be Polyethylene terephthalate (PET) membranes, a PET molding process may be adopted to form the bulges 121 on the second membrane layer 12, and the liquid storing capacity of the waterproof structure may be improved and the time of one internal recycle may be prolonged by designing the quantity and size of the bulges 121 on the second membrane layer 12.

In another example of the disclosure, as shown in Fig. 2 and Fig. 3, the liquid storing part 2 further includes a water locking body 111 arranged on the first membrane layer 11 and located in the liquid storing cavity, and the water locking body 111 may be of hollowed-out structure, protrudes in the same direction as the bulge 121, and are spaced from each other. The water locking body 111 may adopt an injection molding process to be integrated with the first membrane layer 11, so as to lock water entering the liquid storing cavity and ensure that the water may fill the whole liquid storing cavity. Meanwhile, after the external force is applied to empty the water in the liquid storing cavity, the water locking body 111 may be automatically restored to their original state, and cyclic utilization may be carried out while the liquid storing capacity is implemented.

In an example of the disclosure, as shown in Fig. 4, more than one liquid storing parts 2 may be arranged in a matrix mode, and include first liquid storing parts 21 located in an edge region 101 and second liquid storing parts 22 located in a middle region 102. The second liquid storing parts 22 of the middle region 102, the first liquid storing parts 21 located on two sides of the water absorbing part 3, the first liquid storing parts 21 and the adjacent second liquid storing parts 22 communicate with one another respectively. A square sheet base body shown in Fig. 4 is taken as an example, water vapor enters from the water absorbing part 3 below, sequentially enters the first liquid storing parts 21 and the second liquid storing parts 22 in a vertical direction from bottom to top, and then is diffused between the second liquid storing parts 22 and the first liquid storing parts 21 in a transverse direction to gradually fill the liquid storing parts 2. The liquid storing parts 2 provided by the disclosure adopt a vertical and horizontal communicating mode, in other implementations, a spiral arrangement mode, a circumferential arrangement mode and the like may further be adopted. The liquid storing parts 2 opposite to the water absorbing part 3 do not communicate with one another, on the one hand, it may be ensured that water vapor at the opening of the water absorbing part 3 may directly enter the liquid storing parts 2 upwards under the siphon action, so as to ensure power of the water vapor entering the liquid storing parts 2 through the water absorbing part 3 by overcoming the action of gravity, and meanwhile, a non-circulation direction of the liquid storing parts 2 may further be sealed to ensure the leakproofness of the whole waterproof structure.

As shown in Fig. 2, the bulge 121 may be constructed as air sac, and the air sac may be hemispherical or spherical. The water locking body 111 may be constructed as net structure buckled on the first membrane layer 11 and matched with the air sacs in shape, such as a grid hemisphere or a grid sphere, every two adjacent net structures communicate with each other through a capillary groove 201, and every two adjacent air sacs communicate with each other through a channel 202. Adaptive design may be made to the net structure according to the shape of the air sac, each liquid storing part 2 has certain liquid storing capacity through structural design of the bulge 121 and the water locking body 111, the liquid storing parts 2 may communicate with one another by designing the capillary grooves 201 and the channels 202, diffusion and filling of water in the waterproof structure are implemented, and the whole water absorbing capacity is improved.

The water absorbing part 3 includes more than one water absorbing channels arranged in parallel, one end of each of the plurality of water absorbing channels extends to the edge provided with the water absorbing part 3, and the other ends of the plurality of water absorbing channels respectively extend to the liquid storing part 2 closest to the edge. Lengths of the water absorbing channels are not required too long, and under the capillary action, it may be ensured that the water vapor at the opening of the water absorbing part 3 could quickly enter into the closest liquid storing part 2 and complete filling and diffusion actions.

Certainly, there may be only one water absorbing channel. One end of the water absorbing channel extends to the edge provided with the water absorbing part 3, and the other end of the water absorbing channel extends to one of the liquid storing parts 2. Water flows between the plurality of liquid storage parts 2 after entering from the water absorbing channel.

In order to ensure the leakproofness of the whole waterproof structure and avoid the leakage problem when the waterproof structure is applied to an electronic device, in the disclosure, as shown in Fig. 4, the base body 1 has an edge covering region 103 located on a periphery of the edge region 101, and the edge covering region 103 and the edge provided with the water absorbing part 3 jointly constitute an outer contour of the base body 1. The first membrane layer 11 and the second membrane layer 12 perform press fit sealing on the position of the edge covering region 103 to form an integrated sealing structure.

In the disclosure, as shown in Fig. 3, the waterproof structure further includes a fixed layer 13, and the fixed layer 13 is arranged on a surface facing away from the liquid storing part 2 of the base body 1. The fixed layer 13 may be a double-sided adhesive layer, one surface is attached to a bottom surface of the first membrane layer 11, and the other surface is attached to any appropriate position needing waterproofing.

According to a second aspect of the disclosure, as shown in Fig. 1, an electronic device is further provided. The electronic device includes one or more structural members, in order to implement the waterproofing function of the electronic device, the waterproof structure provided by the disclosure is arranged on at least one of the structural members, that is, the disclosure includes an example that the waterproof structure is directly and integrally laid and fixed on a surface of one of the structural members, and the structural member may be a shell of the electronic device, and may further be an internal functional device, such as speakers, microphones, camera modules, etc. By manually pressing the liquid storing part 2, water collected in the liquid storing part 2 is periodically discharged to ensure the waterproofing function of the electronic device. Certainly, the disclosure further includes an example that the waterproof structure is arranged between the two adjacent structural members.

In an example of the disclosure, the electronic device includes a first structural member 4 and a second structural member 5, an interval and an opening 6 communicating with the outside are formed between the first structural member 4 and the second structural member 5, the above waterproof structure is arranged in the interval, and the water absorbing part 3 is arranged towards the opening 6. The electronic device here may be various communication devices such as a mobile phone and a tablet computer, and may further be various wearable devices such as an earphone and a watch. Through the design of additionally arranging the waterproof structure, the waterproofing performance of the electronic device may be improved, and the requirement of various application scenarios is met. The electronic device has all beneficial effects of the above waterproof structure, which is not repeated here.

As shown in Fig. 1, a first surface 41 of the first structural member 4 is in butt joint with a second surface 51 of the second structural member 5 to form the interval, the waterproof structure is arranged between the first surface 41 and the second surface 51, the opening 6 is formed at one end of the first surface 41 and the second surface 51, the water absorbing part 3 is arranged close to the opening 6, the second structural member 5 is located on an outer side of the first structural member 4, and the liquid absorbing part 2 is arranged towards the second structural member 5. When the liquid absorbing part 2 is internally filled with water, external force F may be applied to the outer side of the electronic device towards the second structural member 5, the water in the water absorbing parts 2 is extruded outside through the opening 6 to complete one internal recycle and perform the next cycle, and repetitive cycle utilization of the waterproof structure is implemented. The water in the liquid storing part 2 could be discharged to the outside by the external force F or by the contraction of the liquid storing part 2 itself when reaches the preset value. In the latter examples, the liquid storing part 2 is made of elastic material, which will automatically contract and discharge the water out.

The waterproof structure provided by the disclosure applied to a mobile phone is taken as an example below, the first structural member 4 may be a front shell, the second structural member 5 may be a rear shell, the whole waterproof structure is disposed at a butt-joint surface of the front shell and the rear shell, water vapor enters the water absorbing channel from the opening 6, under the capillary action, the water vapor is introduced into the tiny water absorbing parts 2 and diffused and filled into all water absorbing parts 2 in a transverse direction to be stored, and when the water vapor is stored to a certain degree, under the action of the external force F, water drops in the water absorbing parts 2 are extruded out of the shell to implement the waterproofing performance of the mobile phone.

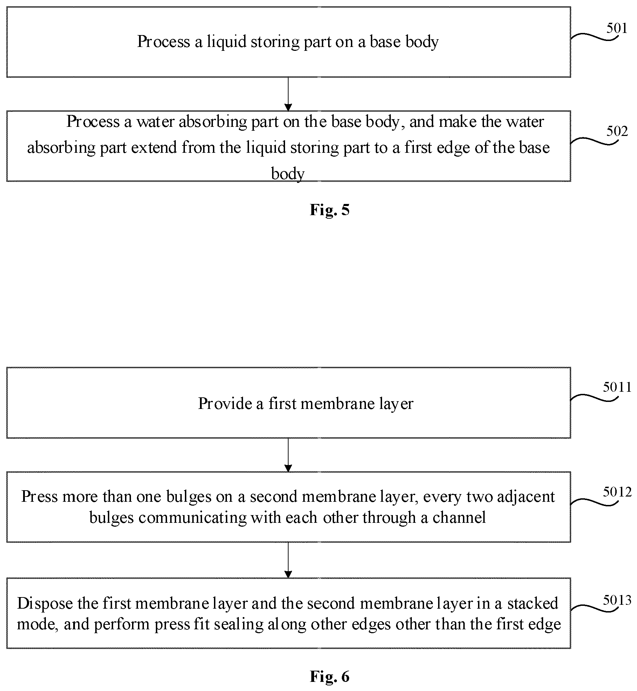

According to a third aspect of the disclosure, as shown in Fig. 5, a manufacturing method of a waterproof structure is further provided. The manufacturing method is used for processing the waterproof structure provided by the disclosure and includes: step 501, a liquid storing part 2 is processed on a base body 1; and step 502, a water absorbing part 3 is processed on the base body 1, and make the water absorbing part 3 extends from the water absorbing parts 2 to a first edge of the base body 1. For the method of processing the liquid storing parts 2 and the water absorbing part 3 on the base body 1, any appropriate process may be adopted, for example, direct injection molding and molding process below are adopted. The manufacturing method is easy and convenient to operate and low in processing cost, and the process efficiency is improved.

In the disclosure, as shown in Fig. 6, step 501 includes: step 5011, a first membrane layer 11 is provided; step 5012, more than one bulges 121 are pressed on a second membrane layer 12, and every two adjacent bulges 121 communicate with each other through a channel 202; and step 5013, the first membrane layer 11 and the second membrane layer 12 are disposed in a stacked mode, and press-fit sealing is performed along other edges other than the first edge (take the waterproof structure as a square sheet as an example, the first edge may be the lower edge, and the other edges are the upper edge and two side edges). The PET mold pressing technology is adopted to simultaneously process the tiny bulges 121 on the first membrane layer 11, press-fit sealing is performed on the first membrane layer 11 and the second membrane layer 12, the liquid storing cavities are formed between the bulges 121 and the first membrane layer 11, and meanwhile, the leakproofness of the whole waterproof structure is ensured.

In the disclosure, in step 5011, more than one water locking bodies 111 are fixed on the first membrane layer 11 in an injection molding mode, and every two adjacent water locking bodies 111 communicate with each other through a capillary groove 201; and in step 5013, the bulges 121 correspond to the water locking bodies 111 in position, and the water locking bodies 111 are sealed in the liquid storing cavities between the bulges 121 and the first membrane layer 11. The water locking bodies 111 are integrally formed on the first membrane layer 11 in an injection molding mode, could lock water in the liquid storing cavities into a blank, so as to make water fill the whole liquid storing cavities. In other implementations, the water locking bodies 111 may further be water locking structures such as sponge and foam.

## Claims

1. A waterproof structure for an electronic device, comprising a base body (1) and a liquid storing part (2) arranged on the base body (1) in a protruding mode, wherein the base body (1) has a water absorbing part (3) located on an edge and communicating with the liquid storing part (2), and the waterproof structure is configured to allow water vapor to enter into the liquid storing part (2) through the water absorbing part (3), and be centrally discharged to the outside when a water volume in the liquid storing part (2) reaches a preset value,
**characterized in that** the base body (1) comprises a first membrane layer (11) and a second membrane layer (12) disposed in a stacked mode, wherein the liquid storing part (2) comprises a bulge (121) formed by the second membrane layer (12) protruding in a direction away from the first membrane layer (11), and a liquid storing cavity communicating with the water absorbing part (3) is formed between the bulge (121) and the first membrane layer (11).

2. The waterproof structure according to claim 1, wherein the liquid storing part (2) further comprises a water locking body (111) arranged on the first membrane layer (11) and located in the liquid storing cavity, and the water locking body (111) is of hollowed-out structure, protrudes in the same direction as the bulge (121), and is spaced from the bulge (121).

3. The waterproof structure according to claim 2, wherein more than one storing parts (2) are arranged in a matrix mode and comprise first liquid storing parts (21) located in an edge region (101) and second liquid storing parts (22) located in a middle region (102), and the second liquid storing parts (22) located in the middle region (102), the first liquid storing parts (21) located on two sides of the water absorbing part (3), the first liquid storing parts (21) and the adjacent second liquid storing parts (22) communicate with one another respectively.

4. The waterproof structure according to claim 3, wherein the bulge (121) is constructed as air sac, the water locking body (111) is constructed as net structure buckled on the first membrane layer (11) and matched with the air sac in shape, every two adjacent net structures communicate with each other through a capillary groove (201), and every two adjacent air sacs communicate with each other through a channel (202).

5. The waterproof structure according to claim 3 or 4, wherein the base body (1) has an edge covering region (103) located on a periphery of the edge region (101), and the edge covering region (103) and the edge provided with the water absorbing part (3) jointly constitute an outer contour of the base body (1).

6. The waterproof structure according to any one of claims 3 to 5, wherein the water absorbing part (3) comprises one or more water absorbing channels, one end of the water absorbing channel extends to the edge provided with the water absorbing part (3), and the other end of the water absorbing channel extends to the liquid storing part (2) closest to the edge.

7. The waterproof structure according to any one of claims 1 to 6, further comprising a fixed layer (13), wherein the fixed layer (13) is arranged on a surface facing away from the liquid storing part (2) of the base body (1).

8. An electronic device, comprising one or more structural members and a waterproof structure according to any one of claims 1 to 7, wherein the waterproof structure is arranged on at least one of the structural members.

9. The electronic device according to claim 8, comprising a first structural member (4) and a second structural member (5), wherein an interval and an opening (6) communicating with the outside are formed between the first structural member (4) and the second structural member (5), the waterproof structure is arranged in the interval, and the water absorbing part (3) is arranged towards the opening (6).

10. The electronic device according to claim 9, wherein a first surface (41) of the first structural member (4) is in butt joint with a second surface (51) of the second structural member (5) to form the interval, the opening (6) is formed at one end of the first surface (41) and the second surface (51), the second structural member (5) is located on an outer side of the first structural member (4), and the liquid storing part (2) protrudes towards the second structural member (5).

11. A manufacturing method of a waterproof structure for an electronic device, wherein the manufacturing method is used for processing a waterproof structure according to any one of claims 1 to 7 and comprises:
processing the liquid storing part (2) on the base body (1); and
processing the water absorbing part (3) on the base body (1), and making the water absorbing part (3) extend from the liquid storing part (2) to a first edge of the base body (1).

12. The manufacturing method of the waterproof structure according to claim 11, wherein the base body (1) comprises a first membrane layer (11) and a second membrane layer (12) disposed in a stacked mode, and the step of processing the liquid storing part (2) on the base body (1) comprises:
providing the first membrane layer (11);
pressing more than one bulges (121) on the second membrane layer (12), every two adjacent bulges (121) communicating with each other through a channel (202); and
disposing the first membrane layer (11) and the second membrane layer (12) in the stacked mode, and performing press fit sealing along other edges other than the first edge.

13. The manufacturing method of the waterproof structure according to claim 12, wherein
in the step of providing the first membrane layer (11), more than one water locking bodies (111) are fixed on the first membrane layer (11) in an injection molding mode, and every two adjacent water locking bodies (111) communicate with each other through a capillary groove (201); and
in the step of disposing the first membrane layer (11) and the second membrane layer (12) in the stacked mode, the bulges (121) correspond to the water locking bodies (111) in position, and the water locking bodies (111) are sealed in liquid storing cavities between the bulges (121) and the first membrane layer (11).

## Patentansprüche

1. Wasserdichte Struktur für eine elektronische Vorrichtung, die einen Basiskörper (1) und ein Flüssigkeitsspeicherteil (2) aufweist, das auf dem Basiskörper (1) in einem vorstehenden Modus angeordnet ist, wobei der Basiskörper (1) einen wasserabsorbierenden Teil (3) aufweist, der sich an einem Rand befindet und mit dem Flüssigkeitsspeicherteil (2) in Verbindung steht, und die wasserdichte Struktur so ausgebildet ist, dass sie es Wasserdampf ermöglicht, durch den wasserabsorbierenden Teil (3) in den Flüssigkeitsspeicherteil (2) einzutreten und zentral nach außen abgeleitet zu werden, wenn ein Wasservolumen in dem Flüssigkeitsspeicherteil (2) einen voreingestellten Wert erreicht,
**dadurch gekennzeichnet, dass** der Basiskörper (1) eine erste Membranschicht (11) und eine zweite Membranschicht (12) aufweist, die in einem gestapelten Modus angeordnet sind, wobei das Flüssigkeitsspeicherteil (2) eine Ausbuchtung (121) aufweist, die durch die zweite Membranschicht (12) gebildet wird, die in einer Richtung weg von der ersten Membranschicht (11) vorsteht, und ein Flüssigkeitsspeicherhohlraum, der mit dem wasserabsorbierenden Teil (3) in Verbindung steht, zwischen der Ausbuchtung (121) und der ersten Membranschicht (11) ausgebildet ist.

2. Wasserdichte Struktur nach Anspruch 1, wobei das Flüssigkeitsspeicherteil (2) ferner einen Wasserverriegelungskörper (111) aufweist, der auf der ersten Membranschicht (11) angeordnet ist und sich in dem Flüssigkeitsspeicherhohlraum befindet, und der Wasserverriegelungskörper (111) aus einer ausgehöhlten Struktur besteht, in der gleichen Richtung wie die Ausbuchtung (121) vorsteht und von der Ausbuchtung (121) beabstandet ist.

3. Wasserdichte Struktur nach Anspruch 2, wobei mehr als ein Speicherteil (2) in einem Matrixmodus angeordnet ist und erste Flüssigkeitsspeicherteile (21), die sich in einem Randbereich (101) befinden, und zweite Flüssigkeitsspeicherteile (22), die sich in einem mittleren Bereich (102) befinden, aufweist, und die zweiten Flüssigkeitsspeicherteile (22), die sich in dem mittleren Bereich (102) befinden, die ersten Flüssigkeitsspeicherteile (21), die sich auf zwei Seiten des wasserabsorbierenden Teils (3) befinden, die ersten Flüssigkeitsspeicherteile (21) und die benachbarten zweiten Flüssigkeitsspeicherteile (22) jeweils miteinander in Verbindung stehen.

4. Wasserdichte Struktur nach Anspruch 3, wobei die Ausbuchtung (121) als Luftsack konstruiert ist, der Wasserverriegelungskörper (111) als Netzstruktur konstruiert ist, die auf der ersten Membranschicht (11) geknickt und in ihrer Form an den Luftsack angepasst ist, jeweils zwei benachbarte Netzstrukturen durch eine Kapillarrille (201) miteinander in Verbindung stehen und jeweils zwei benachbarte Luftsäcke durch einen Kanal (202) miteinander in Verbindung stehen.

5. Wasserdichte Struktur nach Anspruch 3 oder 4, wobei der Basiskörper (1) einen Randabdeckungsbereich (103) aufweist, der an einem Umfang des Randbereichs (101) angeordnet ist, und der Randabdeckungsbereich (103) und der mit dem wasserabsorbierenden Teil (3) versehene Rand gemeinsam eine Außenkontur des Basiskörpers (1) bilden.

6. Wasserdichte Struktur nach einem der Ansprüche 3 bis 5, wobei der wasserabsorbierende Teil (3) einen oder mehrere wasserabsorbierende Kanäle aufweist, ein Ende des wasserabsorbierenden Kanals sich zu dem mit dem wasserabsorbierenden Teil (3) versehenen Rand erstreckt und das andere Ende des wasserabsorbierenden Kanals sich zu dem dem Rand am nächsten liegenden Flüssigkeitsspeicherteil (2) erstreckt.

7. Wasserdichte Struktur nach einem der Ansprüche 1 bis 6, die ferner eine feste Schicht (13) aufweist, wobei die feste Schicht (13) auf einer Oberfläche angeordnet ist, die von dem Flüssigkeitsspeicherteil (2) des Basiskörpers (1) abgewandt ist.

8. Elektronische Vorrichtung, die ein oder mehrere Strukturelemente und eine wasserdichte Struktur nach einem der Ansprüche 1 bis 7 aufweist, wobei die wasserdichte Struktur auf mindestens einem der Strukturelemente angeordnet ist.

9. Elektronische Vorrichtung nach Anspruch 8, die ein erstes Strukturelement (4) und ein zweites Strukturelement (5) aufweist, wobei zwischen dem ersten Strukturelement (4) und dem zweiten Strukturelement (5) ein Zwischenraum und eine mit der Außenseite in Verbindung stehende Öffnung (6) ausgebildet sind, die wasserdichte Struktur in dem Zwischenraum angeordnet ist und der wasserabsorbierende Teil (3) in Richtung der Öffnung (6) angeordnet ist.

10. Elektronische Vorrichtung nach Anspruch 9, wobei eine erste Oberfläche (41) des ersten Strukturelements (4) in Stoßverbindung mit einer zweiten Oberfläche (51) des zweiten Strukturelements (5) steht, um den Zwischenraum zu bilden, die Öffnung (6) an einem Ende der ersten Oberfläche (41) und der zweiten Oberfläche (51) ausgebildet ist, das zweite Strukturelement (5) an einer Außenseite des ersten Strukturelements (4) angeordnet ist, und das Flüssigkeitsspeicherteil (2) in Richtung des zweiten Strukturelements (5) vorsteht.

11. Verfahren zur Herstellung einer wasserdichten Struktur für eine elektronische Vorrichtung, wobei das Herstellungsverfahren zur Verarbeitung einer wasserdichten Struktur nach einem der Ansprüche 1 bis 7 verwendet wird und umfasst:
Verarbeiten des Flüssigkeitsspeicherteils (2) auf dem Basiskörper (1); und
Verarbeiten des wasserabsorbierenden Teils (3) auf dem Basiskörper (1) und Veranlassen, dass sich der wasserabsorbierende Teil (3) ausgehend von dem Flüssigkeitsspeicherteil (2) zu einem ersten Rand des Basiskörpers (1) erstreckt.

12. Verfahren zur Herstellung der wasserdichten Struktur nach Anspruch 11, wobei der Basiskörper (1) eine erste Membranschicht (11) und eine zweite Membranschicht (12) aufweist, die in einem gestapelten Modus angeordnet sind, und der Schritt der Verarbeitung des Flüssigkeitsspeicherteils (2) auf dem Basiskörper (1) umfasst:
Bereitstellen der ersten Membranschicht (11);
Pressen von mehr als einer Ausbuchtung (121) auf der zweiten Membranschicht (12), wobei jeweils zwei benachbarte Ausbuchtungen (121) über einen Kanal (202) miteinander in Verbindung stehen; und
Anordnen der ersten Membranschicht (11) und der zweiten Membranschicht (12) im gestapelten Modus und Durchführen einer Presssitzabdichtung entlang anderer Kanten als der ersten Kante.

13. Verfahren zur Herstellung der wasserdichten Struktur nach Anspruch 12, wobei in dem Schritt des Bereitstellens der ersten Membranschicht (11) mehr als ein Wasserverriegelungskörper (111) auf der ersten Membranschicht (11) in einem Spritzgussmodus fixiert wird, und jeweils zwei benachbarte Wasserverriegelungskörper (111) durch eine Kapillarrille (201) miteinander in Verbindung stehen; und in dem Schritt des Anordnens der ersten Membranschicht (11) und der zweiten Membranschicht (12) im gestapelten Modus die Ausbuchtungen (121) den Wasserverriegelungskörpern (111) in Position entsprechen, und die Wasserverriegelungskörper (111) in Flüssigkeitsspeicherhohlräumen zwischen den Ausbuchtungen (121) und der ersten Membranschicht (11) abgedichtet sind.

## Revendications

1. Structure étanche pour un dispositif électronique, comprenant un corps de base (1) et une partie de stockage de liquide (2) agencée sur le corps de base (1) en mode en saillie, dans laquelle le corps de base (1) a une partie d'absorption d'eau (3) située sur un bord et communiquant avec la partie de stockage de liquide (2), et la structure étanche est configurée pour permettre à de la vapeur d'eau d'entrer dans la partie de stockage de liquide (2) à travers la partie d'absorption d'eau (3), et d'être évacuée de manière centralisée vers l'extérieur lorsqu'un volume d'eau dans la partie de stockage de liquide (2) atteint une valeur prédéfinie, **caractérisée en ce que** le corps de base (1) comprend une première couche de membrane (11) et une deuxième couche de membrane (12) disposées en mode empilé, dans laquelle la partie de stockage de liquide (2) comprend une protubérance (121) formée par la deuxième couche de membrane (12) faisant saillie dans une direction s'éloignant de la première couche de membrane (11), et une cavité de stockage de liquide communiquant avec la partie d'absorption d'eau (3) est formée entre la protubérance (121) et la première couche de membrane (11).

2. Structure étanche selon la revendication 1, dans laquelle la partie de stockage de liquide (2) comprend en outre un corps de blocage d'eau (111) agencé sur la première couche de membrane (11) et situé dans la cavité de stockage de liquide, et le corps de blocage d'eau (111) est de structure évidée, fait saillie dans la même direction que la protubérance (121), et est espacé de la protubérance (121).

3. Structure étanche selon la revendication 2, dans laquelle plus d'une partie de stockage (2) sont agencées en mode matriciel et comprennent des premières parties de stockage de liquide (21) situées dans une région de bord (101) et des deuxièmes parties de stockage de liquide (22) situées dans une région médiane (102), et les deuxièmes parties de stockage de liquide (22) situées dans la région médiane (102), les premières parties de stockage de liquide (21) situées des deux côtés de la partie d'absorption d'eau (3), les premières parties de stockage de liquide (21) et les deuxièmes parties de stockage de liquide (22) adjacentes communiquent les unes avec les autres respectivement.

4. Structure étanche selon la revendication 3, dans laquelle la protubérance (121) est construite comme un sac d'air, le corps de blocage d'eau (111) est construit comme une structure en filet bouclée sur la première couche de membrane (11) et appariée en forme avec le sac d'air, toutes les deux structures en filet adjacentes communiquent l'une avec l'autre par une rainure capillaire (201), et tous les deux sacs d'air adjacents communiquent l'un avec l'autre par un canal (202).

5. Structure étanche selon la revendication 3 ou 4, dans laquelle le corps de base (1) a une région de recouvrement de bord (103) située sur une périphérie de la région de bord (101), et la région de recouvrement de bord (103) et le bord pourvu de la partie d'absorption d'eau (3) constituent conjointement un contour extérieur du corps de base (1).

6. Structure étanche selon l'une quelconque des revendications 3 à 5, dans laquelle la partie d'absorption d'eau (3) comprend un ou plusieurs canaux d'absorption d'eau, une extrémité du canal d'absorption d'eau s'étend jusqu'au bord pourvu de la partie d'absorption d'eau (3), et l'autre extrémité du canal d'absorption d'eau s'étend jusqu'à la partie de stockage de liquide (2) la plus proche du bord.

7. Structure étanche selon l'une quelconque des revendications 1 à 6, comprenant en outre une couche fixe (13), dans laquelle la couche fixe (13) est agencée sur une surface opposée à la partie de stockage de liquide (2) du corps de base (1).

8. Dispositif électronique, comprenant un ou plusieurs éléments structurels et une structure étanche selon l'une quelconque des revendications 1 à 7, dans lequel la structure étanche est agencée sur au moins un des éléments structurels.

9. Dispositif électronique selon la revendication 8, comprenant un premier élément structurel (4) et un deuxième élément structurel (5), dans lequel un intervalle et une ouverture (6) communiquant avec l'extérieur sont formés entre le premier élément structurel (4) et le deuxième élément structurel (5), la structure étanche est agencée dans l'intervalle, et la partie d'absorption d'eau (3) est agencée vers l'ouverture (6).

10. Dispositif électronique selon la revendication 9, dans lequel une première surface (41) du premier élément structurel (4) est en aboutement avec une deuxième surface (51) du deuxième élément structurel (5) pour former l'intervalle, l'ouverture (6) est formée à une extrémité de la première surface (41) et de la deuxième surface (51), le deuxième élément structurel (5) est situé sur un côté extérieur du premier élément structurel (4), et la partie de stockage de liquide (2) fait saillie vers le deuxième élément structurel (5).

11. Procédé de fabrication d'une structure étanche pour un dispositif électronique, dans lequel le procédé de fabrication est utilisé pour traiter une structure étanche selon l'une quelconque des revendications 1 à 7 et comprend : traiter la partie de stockage de liquide (2) sur le corps de base (1) ; et traiter la partie d'absorption d'eau (3) sur le corps de base (1), et Ifaire s'étendre la partie d'absorption d'eau (3) de la partie de stockage de liquide (2) jusqu'à un premier bord du corps de base (1).

12. Procédé de fabrication de la structure étanche selon la revendication 11, dans lequel le corps de base (1) comprend une première couche de membrane (11) et une deuxième couche de membrane (12) disposées en mode empilé, et l'étape de traitement de la partie de stockage de liquide (2) sur le corps de base (1) comprend : la fourniture de la première couche de membrane (11) ; le pressage de plus d'une protubérance (121) sur la deuxième couche de membrane (12), toutes les deux protubérances adjacentes (121) communiquant l'une avec l'autre par un canal (202) ; et la disposition de la première couche de membrane (11) et de la deuxième couche de membrane (12) en mode empilé, et la réalisation d'un scellement par ajustement serré le long d'autres bords que le premier bord.

13. Procédé de fabrication de la structure étanche selon la revendication 12, dans lequel, à l'étape de fourniture de la première couche de membrane (11), plus d'un corps de blocage d'eau (111) sont fixés sur la première couche de membrane (11) en mode de moulage par injection, et tous les deux corps de blocage d'eau adjacents (111) communiquent l'un avec l'autre par une rainure capillaire (201) ; et à l'étape de disposition de la première couche de membrane (11) et de la deuxième couche de membrane (12) en mode empilé, les protubérances (121) correspondent aux corps de blocage d'eau (111) en position, et les corps de blocage d'eau (111) sont scellés dans des cavités de stockage de liquide entre les protubérances (121) et la première couche de membrane (11).
